# DEMANDE DE BREVET EUROPEEN

(11) **EP 0 547 955 A1**
(43) Date de publication de la demande: **23.06.1993**
(21) Numéro de dépôt: 92403393.9
(22) Date de dépôt: 14.12.1992
(51) Int. Cl.: G02B 6/12

(54) **Miroir optique intégré et son procédé de fabrication**

(30) Priorité: 16.12.1991 FR 9115591
(71) Demandeur: COMMISSARIAT A L'ENERGIE ATOMIQUE, F-75015 Paris (FR)
(72) Inventeur: Valette, Serge, F-38100 Grenoble (FR)
(74) Mandataire: Dubois-Chabert, Guy

(57) **Abrégé**

Miroir optique intégré et son procédé de fabrication.

Le miroir optique comporte un guide de lumière (20) réalisé sur une surface (23) d'un substrat (22) et destiné à la propagation d'un faisceau lumineux (36) selon une direction parallèle à ladite surface, une cavité (30) pratiquée dans le guide de lumière (20) comportant dans le sens de la propagation une première (32) et une seconde (34) parois orientées perpendiculairement à ladite direction et présentant en coupe approximativement la forme d'un arc de cercle, la distance (L) séparant les deux parois étant égale au rayon de courbure (R) de la seconde paroi au niveau de l'axe optique (37) du miroir et une couche en matériau réfléchissant (38) déposée uniquement sur la seconde paroi afin de réfléchir le faisceau lumineux vers la première paroi, la seconde paroi formant une surface réfléchissante concave.

## Description

La présente invention a pour objet un miroir pour l'optique intégrée ainsi que son procédé de fabrication. Elle trouve une application dans tous les domaines où l'on désire réfléchir un faisceau lumineux et notamment dans le domaine du traitement des signaux radar en temps réel, par exemple dans des corrélateurs, des analyseurs de spectres ou des dispositifs interférométriques, dans le domaine des communications par voie optique et dans le domaine des capteurs à fibres optiques. Ces capteurs sont notamment utilisés dans les domaines spatial, naval, aéronautique, automobile et sur les chaînes de montage d'un grand nombre d'objets.

Plus spécialement, ce miroir est destiné à équiper une cavité externe de stabilisation d'une diode laser à semi-conducteur.

Les techniques de traitement et/ou de transmission à distance de l'information, étudiées depuis quelques années, utilisent la transmission par onde lumineuse dans des guides de lumière à structure plane. Ces guides de lumière sont constitués d'une couche guidante intercalée entre deux couches supérieure et inférieure de confinement, empilées sur un substrat, la couche guidante ayant un indice de réfraction réel supérieur à celui des couches inférieure et supérieure. La couche supérieure peut, dans certains cas, être remplacée par de l'air.

Les miroirs optiques intégrés constituent l'un des composants de base de tous les circuits optiques intégrés à structure guide planaire.

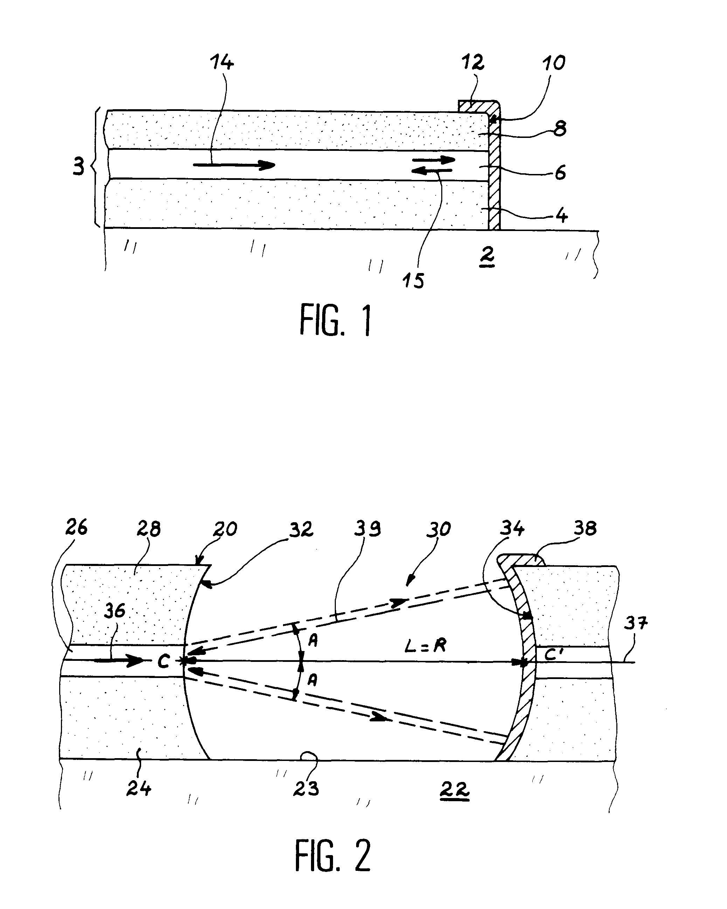

La façon la plus simple de réaliser, actuellement, un miroir en optique intégrée est représentée, en coupe longitudinale, sur la figure 1 annexée.

Sur cette figure, on trouve un substrat 2 supportant un guide de lumière 3 constitué de la couche de confinement inférieure 4 ou couche tampon puis la couche guide 6 et enfin la couche supérieure de confinement 8.

La réalisation du miroir consiste à graver entièrement les couches 4, 6 et 8 du guide jusqu'au substrat et à recouvrir le flanc gravé 10 par une couche de métallisation 12 afin de renvoyer le faisceau incident 14 transmis par la couche 6 à nouveau vers la couche guide 6. Le faisceau réfléchi porte la référence 15.

La couche de métallisation 12 peut être remplacée par un empilement de couches diélectriques jouant le rôle de miroir.

Ce type de miroir est en particulier utilisé pour des structures guides formées sur des substrats en silicium, par exemple du type Si/SiO₂/Si₃N₄/SiO₂, noté OIS, ou du type SilSi0₂/Si0₂ dopé/Si0₂, noté OIS₂ ; le dopage de la couche guide est tel que son indice de réfraction est supérieur à celui des couches de confinement supérieure et inférieure.

Les difficultés de réalisation d'un tel miroir sont essentiellement liées à la réalisation de la gravure de la structure guide elle-même pour les deux raisons suivantes :
- l'épaisseur de gravure de la structure guide peut être importante, par exemple de 25 à 30pm pour une structure OIS₂ utilisée pour les communications optiques ;
- la qualité de la gravure du point de vue de son état de surface et surtout du profil du flanc 10 joue un rôle essentiel sur la valeur du coefficient de réflexion du miroir.

Tout serait parfait, si la gravure de la structure guide était parfaitement perpendiculaire au plan des couches du guide. Malheureusement, cette situation n'existe pas et les véritables profils des miroirs s'écartent plus ou moins notablement du profil idéal entraînant une chute rapide du coefficient de réflexion.

Cette chute est d'autant plus importante que l'incidence du faisceau lumineux 14 véhiculé par la couche guide est proche de la normale au miroir (ou flanc gravé 10).

Dans les structures de type OIS₂, la perte de lumière à la réflexion atteint dans le meilleur des cas près de 3dB (c'est-à-dire 50%) par rapport à la valeur idéale.

Une solution évidente serait de mettre en place des procédés technologiques qui conduiraient à des gravures de la structure guide proche du profil idéal recherché pour les miroirs. Bien que des progrès puissent être espérés dans ce domaine, ceci va entraîner un travail de recherche technologique long et fastidieux, donc coûteux qui ne permettra peut-être sans doute jamais d'atteindre complètement la solution idéale.

La présente invention a justement pour objet un miroir optique intégré et son procédé de fabrication permettant de remédier à ces inconvénients. Il permet en particulier la réalisation de miroirs présentant des coefficients de réflexion égaux au coefficient théorique tout en utilisant les techniques classiques de fabrication des miroirs.

Le principe de l'invention est de réaliser la réflexion du faisceau incident non plus sur le premier flanc gravé de la structure guide, rencontré par le faisceau incident mais sur le second et d'utiliser les profils de gravure obtenus classiquement. Ces flancs de gravure présentent, en coupe, la forme d'arc de cercle dont le centre est, à peu de chose près, situé sur l'axe optique du miroir.

De façon plus précise, l'invention a pour objet un miroir optique intégré comportant un guide de lumière réalisé sur une surface d'un substrat et destiné à la propagation d'un faisceau lumineux selon une direction parallèle à ladite surface, une cavité pratiquée dans le guide de lumière comportant dans le sens de la propagation une première et une seconde parois orientées perpendiculairement à ladite direction et présentant approximativement en coupe la forme d'un arc de cercle, la distance séparant les deux parois étant égale au rayon de courbure de la seconde paroi au niveau de l'axe optique du miroir, et une couche en matériau réfléchissant déposée uniquement sur la seconde paroi afin de réfléchir ledit faisceau lumineux vers la première paroi, la seconde paroi formant une surface réfléchissante concave.

Contrairement aux miroirs intégrés de l'art antérieur, la première paroi rencontrée par le faisceau incident n'est pas recouverte d'une couche réfléchissante et ne sert donc pas à réfléchir le faisceau incident.

Pour améliorer l'efficacité du miroir et en particulier diminuer l'angle de divergence de la lumière guidée dans la cavité, celle-ci peut être avantageusement remplie d'un matériau diélectrique. Ce matériau diélectrique assure de plus une protection mécanique du miroir.

Le miroir intégré de l'invention peut être un miroir "plan", parabolique ou elliptique. Dans ces deux derniers cas, la section droite dans le plan du guide de la seconde paroi est respectivement parabolique ou elliptique et la première paroi est telle que la distance la séparant de la seconde paroi est constante.

Le miroir de l'invention peut aussi être un miroir du type Fresnel éventuellement parabolique ou elliptique. Dans ce cas, la seconde paroi est constituée de plusieurs facettes adjacentes assurant à la fois la réflexion du faisceau lumineux et sa dispersion et la première paroi suit le profil de la seconde paroi de sorte que la distance la séparant de la seconde paroi est constante ou quasi-constante.

En pratique, la distance séparant les deux parois est choisie de l'ordre de 10 à 100µm. La précision sur cette distance est de l'ordre de 10%, ce qui est peu contraignant et permet aux miroirs de l'invention de fonctionner correctement pour tous les rayons mis en jeu, que leur incidence sur la seconde paroi soit normale ou non à cette dernière, contrairement à l'art antérieur.

De façon connue, le guide de lumière comprend une couche inférieure de confinement, une couche guide et une couche supérieure de confinement, la couche guide étant interposée entre les couches de confinement ayant un indice de réfraction supérieur à celui des couches de confinement.

Selon l'invention, la cavité s'étend de la couche supérieure à la couche inférieure de la structure guide, de façon que les rayons lumineux puissent diverger librement dans la cavité et atteindre la seconde paroi sans obstacle.

Le miroir de l'invention peut être réalisé sur un grand nombre de substrats et en particulier sur du verre, du niobate de lithium, du silicium, des matériaux III-V et par exemple sur du GaAs ou de l'InP ou encore sur des matériaux II-VI, par exemple du CdTe.

En particulier, le miroir de l'invention s'applique aux structures suivantes :
- verre/verre dopé par échange d'ions/Si0₂,
- Si/SiO₂/Si₃N₄/SiO₂
- Si/SiO₂/AI₂0₃/SiO₂
- Si/SiO₂/SiOₓN_{y}/SiO₂ avec 0<x<2 et 0<y<4/3,
- Si/SiO₂/SiO₂ dopé/Si0₂,

les dopants de la couche guide en silice étant tels que celle-ci présente un indice de réfraction supérieur à celui des couches adjacentes.

En outre, la silice des couches de confinement peut être utilisée pure ou dopée. Lorsque cette dernière est dopée par un dopant diminuant son indice de réfraction, la couche guide peut éventuellement être réalisée en silice non dopée.

Le dopage de la silice par un matériau augmentant son indice de réfraction peut être effectué par du phosphore, du germanium, du titane ou de l'azote et le dopage de la silice par un dopant diminuant son indice de réfraction peut être réalisé par du bore ou du fluor. Bien entendu, la couche guide doit toujours présenter un indice de réfraction supérieur à celui des couches de confinement.

Il est en outre possible de remplacer le substrat en silicium par un substrat en silice.

Dans une structure du type OIS₁ ou OIS₂, le matériau diélectrique utilisé éventuellement pour remplir la cavité présente un indice de réfraction proche de celui de la silice pure ou dopée ou, dans le cas d'un guide à forte différence d'indice, proche de l'indice effectif du mode guidé.

L'invention a aussi pour objet un procédé de fabrication d'un miroir optique intégré tel que décrit précédemment. Ce procédé consiste à :
- former le guide de lumière sur la face du substrat;
- réaliserun masque de résine photosensible sur le guide de lumière, comportant une ouverture en regard de l'emplacement de la cavité à réaliser ;
- éliminer la zone du guide de lumière non masquée ;
- éliminer le masque de résine, et
- déposer sur la seconde paroi une couche de matériau réfléchissant en utilisant un faisceau d'ions précurseurs de ce matériau, incliné par rapport à la surface du guide.

Pour des structures OIS₁ et OIS₂, les parois en arc de cercle de la tranchée sont obtenues naturellement en utilisant une gravure ionique réactive avec comme gaz d'attaque un gaz fluoré comme notamment du CF₄, du CHF₃, du C₂F₄ ou du SF₆. De préférence, on utilise du CHF₃.

L'invention a encore pour objet une diode laser à semi-conducteur stabilisée par une cavité externe pratiquée dans un guide de lumière destiné à la propagation d'un faisceau lumineux émis par la diode selon une direction déterminée ; cette cavité comportant dans le sens de la propagation une première et une seconde parois orientées perpendiculairement à ladite direction et présentant approximativement en coupe la forme d'un arc de cercle, la distance séparant les deux parois étant égale au rayon de courbure de la seconde paroi au niveau de l'axe optique de la cavité externe, et une couche en matériau réfléchissant déposée uniquement sur la seconde paroi afin de réfléchir ledit faisceau lumineux vers la première paroi, la seconde paroi formant une surface réfléchissante concave, la première paroi de la cavité constituant une face d'entrée de la diode.

D'autres caractéristiques et avantages de l'invention ressortiront mieux de la description qui va suivre, donnée à titre illustratif et non limitatif, en référence aux figures annexées, dans lesquelles :
- la figure 1, déjà décrite, représente schématiquement, en coupe longitudinale, un miroir optique intégré conforme à l'art antérieur ;
- la figure 2 représente schématiquement, en coupe longitudinale, un miroir optique intégré "plan" conforme à l'invention ;
- la figure 3 représente schématiquement, en vue de dessus, un miroir parabolique ou elliptique intégré conforme à l'invention ;
- la figure 4 représente schématiquement, en vue de dessus, un miroir optique intégré de Fresnel, conforme à l'invention ;
- les figures 5a et 5b illustrent schématiquement les différentes étapes de fabrication d'un miroir intégré conforme à l'invention, selon une première variante ;
- la figure 6 représente, schématiquement en coupe longitudinale, une variante de réalisation d'un miroir intégré conforme à l'invention ;
- les figures 7a et 7b illustrent schématiquement les différentes étapes de fabrication d'un miroir intégré conforme à l'invention, selon une seconde variante ; et
- les figures 8 et 9 représentent schématiquement, respectivement en coupe longitudinale et en vue de dessus, une diode laser stabilisée par une cavité externe, constituée d'un miroir conforme à l'invention.

Sur la figure 2, on a représenté schématiquement un miroir "plan" intégré conforme à l'invention. Cette figure est une vue en coupe dans un plan perpendiculaire au plan de propagation de la lumière dans la structure guide.

Comme pour l'art antérieur, le miroir optique de l'invention est formé dans une structure guide 20 reposant sur la surface supérieure 23 d'un substrat 22, par exemple en silicium ou en silice.

La structure guide 20 est constituée de trois couches superposées : une couche inférieure de confinement 24 en silice pure ou dopée, une gouche guide 26 en alumine, nitrure de silicium, oxynitrure de silicium ou silice (pure ou dopée) à haut indice de réfraction et une couche supérieure de confinement 28 en silice pure ou dopée.

La silice de ces couches peut être dopée soit par un dopant diminuant son indice de réfraction (bore ou fluor) ou par un dopant augmentant son indice de réfraction (germanium, azote, phosphore, titane). Le dopage de la silice doit être tel que la couche guide 26 présente un indice de réfraction supérieur à celui des couches 24 et 28.

Pour une structure OIS₁, les couches 24,26 et 28 présentent respectivement des épaisseurs de 1 à 8wm, de 10 à 250nm et de 1 à 8wm.

Pour une structure OIS₂, les couches 24,26 et 28 ont respectivement des épaisseurs de 6 à 15wm, de 1 à 10µm et de 2 à 12µm.

Conformément à l'invention, la structure guide 20 comporte une cavité 30 définie par gravure de l'empilement des couches 24, 26 et 28. Cette cavité 30 comporte une paroi d'entrée 32 (ou première paroi) et une paroi de sortie 34 (ou seconde paroi) orientées perpendiculairement au faisceau incident 36 véhiculé par la couche guide selon une direction parallèle à la surface 23 du substrat, c'est-à-dire parallèle au plan du guide. Les parois 32 et 34 présentent, dans le plan de la figure 2, la forme approximative d'arc de cercle dont les centres respectivement C et C' sont à peu de chose près situés sur l'axe optique 37 du miroir.

Selon l'invention, la distance séparant les parois 32 et 34 de la cavité 30, notée L, est égale au rayon de courbure R de la paroi 34.

En pratique, la distance L est de l'ordre de 10 à 100wm. Sa précision est de l'ordre de 10%, ce qui est peu contraignant et permet au miroir de l'invention de fonctionner pour tous les rayons lumineux mis en jeu.

La forme exacte des parois dépend des conditions de gravures de la cavité et peut donc être adaptée, dans une certaine mesure, pour tenir compte des particularités des différents guides d'ondes (ouverture numérique notamment).

La seconde paroi 34 définit un miroir concave pour le faisceau incident 36 et sert à réfléchir la lumière incidente 32 vers la paroi 32. Le faisceau réfléchi porte la référence 39.

Selon l'invention, une couche 38 en matériau réfléchissant par exemple en métal est déposée uniquement sur la paroi 34 de la cavité.

Cette couche 38 est en particulier en aluminium, en or, en argent, etc. Elle présente une épaisseur de 50nm à 1000nm typiquement.

La paroi d'entrée 32 de la cavité 30 présente aussi en coupe la forme d'un arc de cercle.

Dans le mode de réalisation représenté sur la figure 2, la paroi 32 a en général une concavité inverse de celle de la paroi 38. Elle assure une divergence du faisceau incident 36 d'un angle A par rapport à l'axe optique 37 du miroir.

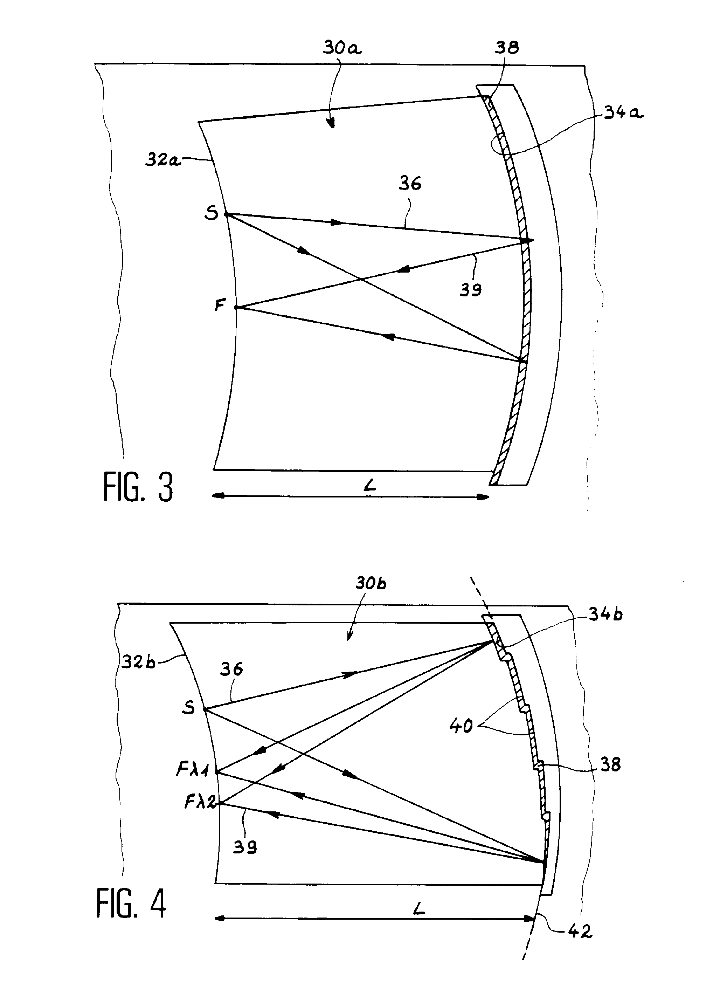

Sur la figure 3, on a représenté schématiquement un miroir parabolique ou elliptique conforme à l'invention, la figure 3 est une vue de dessus de ce miroir et donc dans le plan du guide. Dans ce type de miroir, pour un point source lumineux S dans la couche guide 26, le point de focalisation F est décalé dans le plan du guide, parallèle à la surface 23 du substrat.

Le point source S peut être fourni soit par un dioptre intégré (lentille intégrée du type Fresnel ou autres), soit par l'extrémité d'un microguide de lumière.

Le point de focalisation F peut également correspondre à l'extrémité d'un microguide. En général, S et F sont situés sur la première paroi 32a.

Comme précédemment, seule la seconde paroi 34a de la cavité 30a, rencontrée par le faisceau incident 36 est recouverte d'une couche réfléchissante 38.

Conformément à l'invention, seule cette face réfléchissante 34a a strictement besoin d'être parabolique ou elliptique suivant que le miroir est un miroir parabolique ou elliptique. La paroi d'entrée 32a de la cavité 30a, qui n'intervient que pour diffracter la lumière incidente 36, suit le profil de la paroi 34a de sorte que la distance L séparant la surface 32a de la surface 34a reste constante du fond de la cavité à sa surface. Ainsi, la paroi 32a a une concavité identique à celle de la paroi 34a et présente donc une forme elliptique ou parabolique.

Sur la figure 4, on a représenté schématiquement, en vue de dessus, un miroir intégré dispersif du type Fresnel conforme à l'invention. Ce miroir comporte une cavité 30b dont la seconde paroi 34b présente la forme générale d'un arc de cercle dans un plan perpendiculaire au plan de propagation (c'est-à-dire dans un plan perpendiculaire à celui de la figure 4). De plus, cette paroi 34b est constituée de multiples facettes 40 qui assurent à la fois la réflexion de la lumière incidente 36 et sa dispersion en fonction de la longueur d'onde.

Ainsi, ce miroir pour un point source lumineux S' multi-longueurs d'ondes dans la couche guide et en particulier de longueurs d'ondes Â1 et λ₂, les points de focalisation de la paroi 34b de la cavité 30b, et donc du miroir, sont décalés dans le plan du guide en F2,₁ et FÂ2. De même que précédemment, les points S', Fλ₁ et FÂ2 peuvent correspondre à des extrémités de microguides de lumière réalisés dans une opération antérieure ; l'orientation des microguides dans lesquels la lumière est refocalisée est choisie de façon à favoriser le couplage de lumière (en général suivant la direction du rayon médian).

Le miroir de la figure 4 est en particulier un miroir elliptique.

Comme pour le miroir représenté sur la figure 3, la seconde paroi 34b de la cavité 30b est recouverte d'une couche réfléchissante 38. Par ailleurs, la première paroi 32b rencontrée par le faisceau incident 36 suit le profil de la paroi 34b à une distance Légale au rayon de courbure moyen de la paroi 34b.

Compte tenu des faibles décalages des facettes 40, typiquement de 1 µm, il n'est pas nécessaire de reproduire ces facettes sur la paroi 32b. Cette dernière peut donc suivre l'enveloppe 42 de la paroi 34b.

En outre, comme dans le mode de réalisation de la figure 3, les deux parois 32b et 34b ont une forme concave.

La description qui suit concerne la fabrication d'un miroir optique conforme à l'invention.

Cette description est faite pour un miroir optique "plan" tel que représenté sur la figure 2. Mais bien entendu, ce procédé s'applique aussi à la fabrication des autres types de miroir.

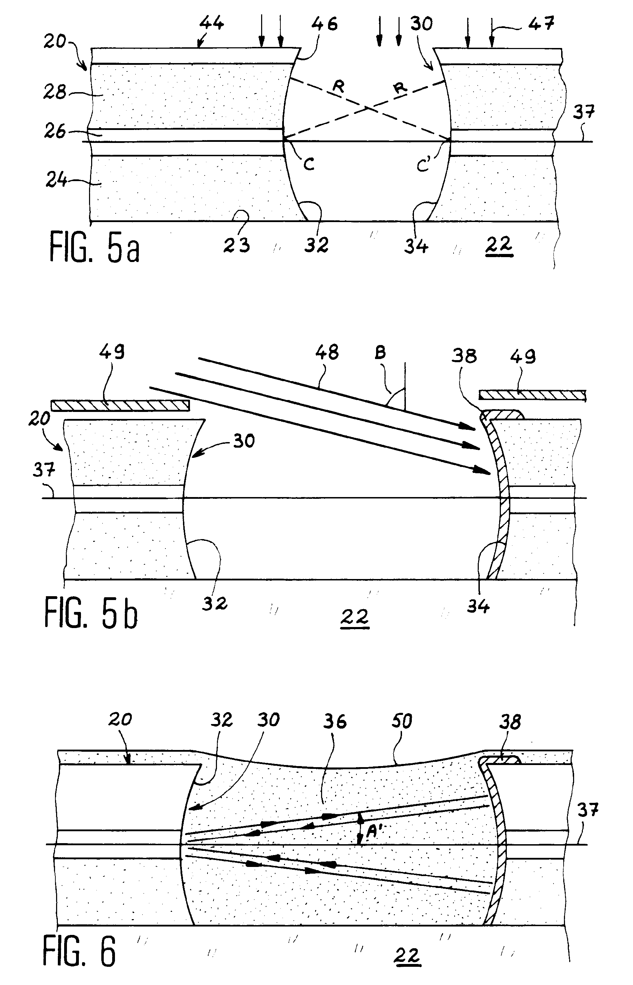

En référence à la figure 5a, la première étape du procédé consiste à former le guide de lumière 20 sur la surface 23 du substrat 22 en déposant successivement les couches 24, 26 et 28, par oxydation thermique du substrat pour la couche 24 et par dépôt chimique en phase vapeur éventuellement assisté par plasma pour les couches 26 et 28. Les techniques de dépôt de ces couches sont conformes à l'art antérieur.

On réalise ensuite, par les procédés classiques de photolithographie, un masque de résine 44 comportant une ouverture 46 à l'emplacement où l'on souhaite réaliser la cavité 30 du miroir. Ce masque 44 est réalisé par exemple selon la technique tricouche bien connue de l'homme de l'art (dépôts successifs d'une couche inférieure de résine, d'une couche de diélectrique et d'une couche supérieure de résine, réalisation d'un masque dans la couche supérieure de résine, gravure de la couche diélectrique, élimination de la couche supérieure de résine puis utilisation de ce masque diélectrique pour la gravure de la résine inférieure et enfin élimination du masque diélectrique).

On effectue alors une gravure ionique réactive à forte puissance (250 à 400W) des trois couches 28, 26 et 24 du guide en utilisant un agent 47 fluoré et en particulier du CHF₃ à haute pression (>90mT soit >12Pa dans la machine utilisée). On obtient ainsi une cavité 30 en regard de l'ouverture 46 du masque de résine 44, dont les parois 32 et 34 ont, en coupe, la forme d'arc de cercle de rayon R et dont les centres respectivement C et C' sont situés sur l'axe optique 37. La cavité présente une forme en tonneau avec un maximum de largeur sur l'axe optique 37.

La gravure ionique réactive de la silice à base de composés fluorés permet de réaliser des formes gravées diverses qui dépendent de la pression des gaz utilisés (CHF₃+O_{Z} ou autres), de la puissance utilisée, du taux d'oxygène et de la résistance du masque à l'agent d'attaque.

De manière générale, sous forte puissance et à haute pression, le nombre de collisions entre l'agent d'attaque et le matériau à graver augmente et tend à diminuer l'anisotropie de la gravure.

Ceci conduirait donc à une gravure non verticale avec ouverture maximale sur le dessous mais en pratique le masque, s'il résiste bien à l'attaque (bonne sélectivité), vient contrecarrer l'obtention de cette forme ; ceci est le cas avec un masque tricouche (résine épaisse/Si0₂/résine mince).

Contrairement à l'invention, avec des épaisseurs de silice plus faibles que celles utilisées ici et en particulier avec la structure 01S₁, on peut travailler à plus faible puissance et plus faible pression et obtenir ainsi des profils plus verticaux.

Après élimination du masque de résine 44, par exemple à l'aide d'un solvant adapté ou d'un plasma d'oxygène, on effectue, comme représenté sur la figure 5b, le dépôt de la couche métallique 38 sur la paroi 34 de la cavité 30.

Ce dépôt est réalisé en envoyant un faisceau d'ions 48, par exemple à travers un masque métallique 49, incliné d'un angle B par rapport à la surface du guide 20. Typiquement, B vaut de 20 à 80° pour L valant de 10 à 100µm. Ce faisceau d'ions 48 peut résulter d'une évaporation sous vide ou d'une pulvérisation cathodique.

Du fait de l'inclinaison, la paroi 32 n'est en général pas touchée par la métallisation et le surplus de métal peut ensuite être enlevé par gravure. Dans ce cas, la métallisation de la paroi peut se faire sans masque 49.

On peut aussi procéder par "lift off' (dépôt d'un masque de résine, métallisation, élimination de la résine et du métal le recouvrant) pour former le dépôt 38.

Il est aussi possible de remplacer le dépôt métallique par un dépôt multicouche diélectrique suivant le même principe.

Sur la figure 6, on a représenté schématiquement, en coupe, une variante de réalisation du miroir conforme à l'invention. Dans cette variante, le miroir se distingue des précédents par le remplissage de la cavité 30 par un matériau diélectrique 50 présentant un indice de réfraction de préférence proche de celui des couches 24, 26 et 28 du guide et donc, dans le cas présent, de la silice pure ou de la silice dopée ou dans le cas de fortes différences d'indice de réfraction, proche de l'indice effectif du mode guidé (cas des guides OIS1). En particulier, ce diélectrique 50 peut être du gel de silice ou une colle optique.

Ce diélectrique 50 assure notamment la protection mécanique du miroir. Il permet en outre d'améliorer l'efficacité de ce miroir en diminuant l'angle de divergence A' de la lumière guidée dans la cavité 30. Il permet en outre de réduire les pertes de lumière par réflexion du type Fresnel sur la première paroi 32 de la cavité.

Le remplissage de la cavité 30 peut être réalisé soit par dépôt chimique en phase vapeur, soit avec une seringue suivant des circuits de remplissage préalablement gravés, soit encore à la tournette.

Dans le cas de structures guides constituées de matériaux très différents, telles que les structures Si/SiO₂/Si₃N₄/SiO₂ ou Si/SiO₂/Al₂O₃/SiO₂ la gravure du matériau de coeur (SiₐN₄ou A1₂0₃) peut être différente de celle des matériaux environnants (Si0₂).

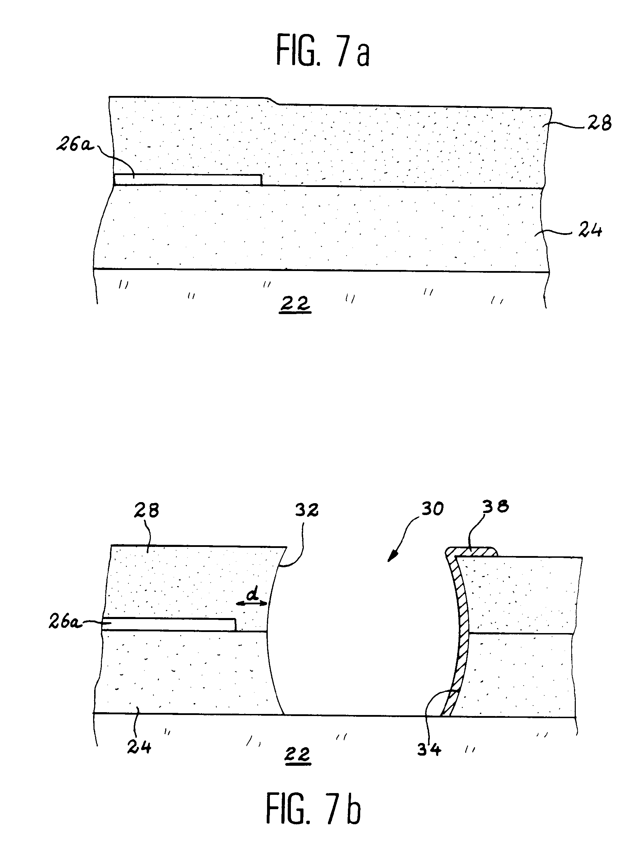

Dans ce cas, on réalise avantageusement le miroir comme représenté sur les figures 7a et 7b :
- 1 ) - dépôt des couches inférieure 24 et guide 26 de la structure guide ;
- 2) - gravure de la couche guide sous forme d'un guide planaire ou microguide 26a (figure 7a) de façon à ne garder du matériau de coeur qu'en amont de la première paroi 32 de la cavité 30 à réaliser ;
- 3) - dépôt de la couche de confinement supérieure 28 sur la structure obtenue en 2 (figure 7a) ;
- 4) - réalisation de la cavité 30 par gravure des couches de confinement inférieure etsupérieu- re 24 et 28, puis dépôt de la couche métallique 38 (figure 7b).

La distance d entre l'extrémité du coeur du guide 26a et la première paroi 32 du miroir est faible (quelques micromètres).

Ce procédé a l'avantage de ne conduire qu'à graver profondément qu'un seul type de matériau (ici la silice) et d'éviter d'éventuels décrochements de gravure donc de profil de la paroi 34, dus à des différences de vitesse d'attaque des matériaux en gravure sèche.

Le miroir décrit précédemment et son procédé de fabrication peuvent être utilisés avantageusement pour stabiliser une diode laser à semi-conducteur à l'aide d'une cavité externe.

Les avantages d'une stabilité par cavité externe sont :
- un fonctionnement de la diode sur un seul mode longitudinal,
- une stabilité fréquentielle du fait de l'absence de saut de mode.

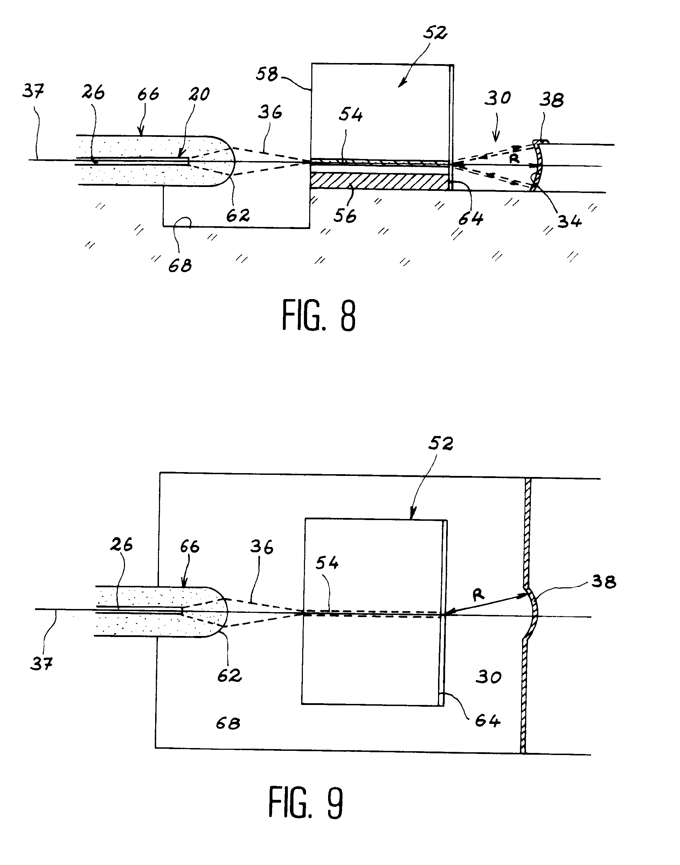

Sur les figures 8 et 9, on a représenté, respectivement en coupe longitudinale et en vue de dessus, une diode laser stabilisée parune cavité externe équipée d'un miroir de l'invention, tel que décrit en référence à la figure 2.

La diode 52 pourvue d'une zone active 54 planaire ou confinée est hybridée et fixée sur le substrat 22 par une soudure métallique 56. Cette diode est réalisée en particulier en matériau III-V selon les techniques connues. Elle comporte une face de sortie 58 et une face d'entrée 60, obtenues par clivage, situées respectivement en regard d'une lentille de focalisation 62, destinée à focaliser la lumière 36 émise par la diode dans le guide optique 20, et d'une cavité externe constituée par la cavité 30 du miroir de l'invention.

L'axe optique 37 du miroir et donc de la cavité externe passe par la zone active 54.

La face d'entrée 60 de la diode est équipée d'un revêtement anti-réfléchissant 64 servant de miroir semi-transparent ; elle constitue la première paroi du miroir. La couche métallique 38 formée sur la seconde paroi 34 du miroirde l'invention permet de réfléchir la lumière sortant du miroir semi-transparent 64 vers la zone active 54.

La lentille de focalisation 62 est formée à l'extrémité d'une languette 66 définie dans le guide optique 20 et surplombant un évidement 68 pratiqué dans le substrat 22. La languette est obtenue en effectuant deux gravures successives : la première est réalisée en même temps que la gravure de la cavité 30 et sert à dégager le guide optique et, la seconde sert à dégager la languette 66 du substrat et à former l'évidement 68. Cette seconde gravure est une gravure micro-onde utilisant des gaz réactifs tels que Ar, SF₆ et 0₂.

La lentille 62 est obtenue en faisant fondre l'extrémité de la languette 66 par illumination laser à une longueur d'onde absorbée par la silice telle que l'émission d'un laser à CO₂.

La distance L séparant la face d'entrée de la diode et la couche métallique 38 est dans ce cas typiquement de 30 à 300f..lm et égale au rayon de courbure R du miroir ; ceci permet de réinjecter un maximum de lumière dans la diode et de la faire oscillersur la cavité externe.

La face réfléchissante 38 du miroir de l'invention présente aussi, en vue de dessus, une forme sphérique de même rayon de courbure R.

## Revendications

1. Miroir optique intégré comportant un guide de lumière (20) réalisé sur une surface (23) d'un substrat (22) et destiné à la propagation d'un faisceau lumineux (36) selon une direction parallèle à ladite surface, une cavité (30, 30a, 30b) pratiquée dans le guide de lumière (20) comportant dans le sens de la propagation une première (32, 32a, 32b) et une seconde (34, 34a, 34b) parois orientées perpendiculairement à ladite direction et présentant approximativement en coupe la forme d'un arc de cercle, la distance (L) séparant les deux parois étant égale au rayon de courbure (R) de la seconde paroi au niveau de l'axe optique (37) du miroir, et une couche en matériau réfléchissant (38) déposée uniquement sur la seconde paroi afin de réfléchir ledit faisceau lumineux vers la première paroi, la seconde paroi formant une surface réfléchissante concave.

2. Miroir intégré selon la revendication 1, de forme parabolique ou elliptique, caractérisé en ce que la section droite dans le plan du guide de la seconde paroi (34a) est respectivement parabolique ou elliptique et en ce que la première paroi (32a) est telle que la distance la séparant de la seconde paroi est constante.

3. Miroir intégré selon la revendication 1 ou 2 du type de Fresnel, caractérisé en ce que la seconde paroi (34b) est constituée de plusieurs facettes (40) adjacentes assurant à la fois la réflexion du faisceau lumineux et sa dispersion et en ce que la première paroi (32b) suit le profil (42) de la seconde paroi de sorte que la distance (L) séparant la seconde paroi est constante ou quasi-constante.

4. Miroir intégré selon l'une quelconque des revendications 1 à 3, caractérisé en ce que la distance (L) séparant les deux parois est choisie de 10 à 100 f..lm avec une précision de l'ordre de 10%.

5. Miroir intégré selon l'une quelconque des revendications 1 à 4, caractérisé en ce que la cavité (30) est remplie d'un matériau diélectrique (50) assurant une protection mécanique du miroir.

6. Miroir intégré selon l'une quelconque des revendications 1 à 5, caractérisé en ce que le guide de lumière comprend une couche inférieure (24) de confinement, une couche guide (26, 26a) et une couche supérieure (28) de confinement, la couche guide (26, 26a) étant interposée entre les couches de confinement et ayant un indice de réfraction supérieur à celui des couches inférieure et supérieure et en ce que la cavité (30, 30a, 30b) s'étend de la couche supérieure à la couche inférieure.

7. Miroir intégré selon la revendication 6, caractérisé en ce que le substrat (22 est en silicium ou en silice, la couche supérieure (28) et la couche inférieure (24) sont des couches de silice pure ou éventuellement dopée et la couche guide (26, 26a) est en silice dopé, en alumine, en nitrure de silicium ou en oxyniture de silicum.

8. Miroir intégré selon la revendication 7, caractérisé en ce que la cavité est remplie d'un matériau ayant un indice de réfraction proche de celui de la silice pure ou dopée ou proche de l'indice effectif du mode guidé.

9. Miroir intégré selon l'une quelconque des revendications 6 à 8, caractérisé en ce que la couche guide est gravée (26a) de façon à ce qu'elle ne subsiste qu'en amont de la première paroi (32).

10. Procédé de fabrication d'un miroir optique intégré comportant un guide de lumière (20) réalisé sur une surface (23) d'un substrat (22) et destiné à la propagation d'un faisceau lumineux (36) selon une direction parallèle à ladite surface, une cavité (30, 30a, 30b) pratiquée dans le guide de lumière (20) comportant dans le sens de la propagation une première (32, 32a, 32b) et une seconde (34, 34a, 34b) parois orientées perpendiculairement à ladite direction et présentant approximativement en coupe la forme d'un arc de cercle, la distance (L) séparant les deux parois étant égale au rayon de courbure (R) de la seconde paroi au niveau de l'axe optique (37) du miroir, caractérisé en ce qu'il consiste à :
- former le guide de lumière (20) sur la surface (23) du substrat (22) ;
- réaliser un masque (44) de résine photosensible sur le guide de lumière, comportant une ouverture (46) en regard de l'emplacement de la cavité à réaliser ;
- éliminer la zone du guide de lumière non masquée ;
- éliminer le masque (44) de résine, et
- déposer sur la seconde paroi une couche (38) de matériau réfléchissant en utilisant un faisceau d'ions (48) précurseurs de ce matériau, incliné par rapport à la surface du guide.

11. Procédé selon la revendication 10, caractérisé en ce que le substrat (22) est en silicium ou en silice et en ce que le guide de lumière comporte une couche inférieure (24) de confinement en silice pure ou éventuellement dopée, une couche guide (26, 26a) en silice dopé, en alumine, en nitrure de silicium ou en oxynitrure de silicium et une couche supérieure (28) de confinement en silice pure ou éventuellement dopée, la couche guide (26, 26a) étant interposée entre les couches de confinement et ayant un indice de réfraction supérieur à celui des couches inférieure et supérieure.

12. Procédé selon la revendication 11, caractérisé en ce que la gravure est réalisée avec un gaz fluoré.

13. Procédé selon l'une quelconque des revendications 10 à 12, caractérisé en ce que l'on forme le guide en a) déposant une couche inférieure de confinement (24) sur un substrat (22) ; en b) déposant une couche guide (26) sur la couche inférieure de confinement ; en c) gravant la couche guide (26a) de façon à ne garder du matériau de la couche guide qu'en amont de la première paroi (32) de la cavité (30) à réaliser ; et en d) déposant une couche supérieure de confinement (28) sur la structure obtenue en c).

14. Diode laser à semi-conducteur stabilisée par une cavité externe (30) pratiquée dans un guide de lumière (20) destiné à la propagation d'un faisceau lumineux (36) émis par la diode selon une direction déterminée ; cette cavité comportant dans le sens de la propagation une première (60) et une seconde (34) parois orientées perpendiculairement à ladite direction et présentant approximativement en coupe la forme d'un arc de cercle, la distance (L) séparant les deux parois étant égale au rayon de courbure (R) de la seconde paroi au niveau de l'axe optique (37) de la cavité externe (30), et une couche en matériau réfléchissant (38) déposée uniquement sur la seconde paroi afin de réfléchir ledit faisceau lumineux vers la première paroi, la seconde paroi formant une surface réfléchissante concave, la première paroi de la cavité constituant une face d'entrée (60) de la diode.
